# EUROPÄISCHE PATENTSCHRIFT

(11) **EP 0 267 555 B1**
(45) Veröffentlichungstag und Bekanntmachung des Hinweises auf die Patenterteilung: **12.02.1997**
(21) Anmeldenummer: 87116416.6
(22) Anmeldetag: 06.11.1987
(51) Int. Cl.: H01J 37/14, H01J 37/28, H01J 37/244, G01R 31/28

(54) **Spektrometerobjektiv für Korpuskularstrahlmessgeräte und Verfahren zur Untersuchung von Proben.**
Spectrometer objective for a corpuscular beam measuring apparatus and method for examining samples.
Objectif de spectromètre pour appareils de mesure par faisceau corpusculaire et procédé pour l'examen d'échantillons.

(30) Priorität: 13.11.1986 DE 3638682
(43) Veröffentlichungstag der Anmeldung: 18.05.1988
(73) Patentinhaber: ADVANTEST CORPORATION, Shinjuku-ku, Tokyo 163-08 (JP)
(72) Erfinder: Feuerbaum, Hans-Peter, Dr.-Ing., D-8000 München 83 (DE); Frosien, Jürgen, Dr.-Ing., D-8012 Ottobrunn (DE)
(74) Vertreter: Tetzner, Volkmar, Dr.-Ing. Dr. jur.

(56) Entgegenhaltungen:
- EP-A- 0 138 610
- RASTER-ELEKTRONENMIKROSKOPIE, zweite Auflage, 1977, Seiten 142-151,164-167, Springer-Verlag, Berlin, DE; L. REIMER et al.
- JOURNAL OF VACUUM SCIENCE & TECHNOLOGY/B, Band 3, Nr. 1, Januar-Februar 1985, 2. Serie, Seiten 383-385, American Vacuum Society, Woodbury, NY, US; A. ITO et al.: "Improved energy analyzer for voltage measurement in electron beam probing for LSI diagnosis"
- PATENT ABSTRACTS OF JAPAN, vol. 10, no. 121 (E-401)[2178], 7. Mai 1986; & JP-A-60 254 741 (FUJITSU K.K.) 16-12-1985
- JOURNAL OF PHYSICS E/SCIENTIFIC INSTRUMENTS, Band 19, Nr. 10, Oktober 1986, Seiten 847-852, The Institute of Physics, Bristol, GB; K. NAKAMAE et al.: "A hemispherical retarding-field energy analyser with a microchannel plate detector and a high extraction field for voltage measurement in the scanning electron microscope"
- JOURNAL OF VACUUM SCIENCE & TECHNOLOGY B, Band 4, Nr. 1, Januar-Februar 1986, 2. Serie, Seiten 217-220, New York, NY, US; S.C.J. GARTH et al.: "Magnetic field extraction of secondary electrons for accurate integrated circuit voltage measurement"
- THE REVIEW OF SCIENTIFIC INSTRUMENTS, Band 40, Nr. 12, Dezember 1969, Seiten 1636-1637; A. SPETH: "A simply instrumented means of displaying magnetic contrast in the scanning electron micoroscope"
- PATENT ABSTRACTS OF JAPAN, Band 6, Nr. 233 (P-156)[1111], 19. November 1982; & JP-A-57 133 358 (FUJITSU K.K.) 18-08-1982
- PROCEEDINGS OF THE XITH INTERNATIONAL CONGRESS ON ELECTRON MICROSCOPY, Kyoto, 31. August - 7. September 1986, Band 1 (Non-biology), Seiten 625-626, The Japanese Society of Electron Microscopy, Tokyo, JP; E. PLIES et al.: "A new objective lens with in-lens spectrometer for electron beam testing"

## Beschreibung

Die Erfindung betrifft ein Spektrometerobjektiv für Korpuskularstrahlmeßgeräte nach dem Oberbegriff des Patentanspruchs 1 sowie ein Verfahren zur Untersuchung von Proben gemäß dem Gattungsbegriff des Anspruches 12.

Ein solches Spektrometerobjektiv ist aus der Veröffentlichung von E. Plies "A new objective lens with in-lens spectrometer for electron beam testing", Proc. XIth Int. Cong. on Electron Microscopy, Kyoto, 31.08 - 07.09.86, Seiten 625-626 bekannt. Dieses Spektrometerobjektiv, das im wesentlichen aus einer kurzbrennweitigen magnetischen Objektivlinse, einer innerhalb der Objektivlinse angeordneten Ablenkeinheit und einem elektrostatischen Gegenfeldspektrometer besteht, bildet die Komponente der elektronenoptischen Säule eines Elektronenstrahlmeßgerätes, mit der sowohl die von einer Hochstromelektronenquelle emittierten Primärelektronen als auch die auf einer Probe ausgelösten Sekundär-elektronen in einen auf der optischen Achse des Systems liegenden Punkt fokussiert werden. Der Fokus der auf hohe kinetische Energien beschleunigten Sekundärelektronen liegt hierbei im Zentrum eines kugelsymmetrischen Gegenfeldes, das man in einem oberhalb der Objektivlinse angeordneten Spektrometerteil mit Hilfe eines entsprechend ausgebildeten Elektrodenpaares erzeugt. Um eine gute Fokussierung der Sekundärelektronen zu gewährleisten ist man gezwungen, die unmittelbar oberhalb der Probe angeordnete Absaugelektrode auf ein hohes positives Potential zu legen. Hohe Absaugfelder (E ≈ 1 bis 2 kV/mm) im Bereich der Probe sollten aber insbesondere bei der Überprüfung der Funktionsweise mikroelektronischer Bauelemente vermieden werden. Darüberhinaus wirken sich Störungen der Homogenität des Absaugfeldes, wie sie insbesondere bei stark strukturierten Proben auftreten, ungünstig auf die Ortsauflösung (≈ Durchmesser der Elektronensonde auf der Probe) des Elektronenstrahlmeßgerätes aus.

Ein Spektrometerobjektiv gemäß dem Oberbegriff des Anspruches 1 ist aus der EP-A-0 138 610 bekannt.

Im Journal of Vaccum Science & Technology/b, Band 3, Nr. 1, Januar-Februar 1985, 2. Serie, S. 383-385; A. Ito et al.: "Improved energy analyser for voltage measurement in electron beam probing for LSI diagnosis" werden die Sekundärelektronen mit hoher Absaugfeldstärke von der Probe abgesaugt und in einem kugelsymmetrischen Gegenfeld abgebremst und gelangen anschließend zu einem Detektor.

Aus der JP-A-60 254 741 ist ferner eine ähnliche Anordnung bekannt, bei der die abgesaugten Sekundärelektronen mittels einer elektrostatischen Linse in einem imaginären Crossover-Punkt fokussiert werden, der dem Mittelpunkt der kugelsymmetrischen Gegenfeldelektroden entspricht.

Im Journal of Physics E/Scientific Instruments, Band 19, Nr. 10, Oktober 1986, S.847-852, K. Nakamae et al.: "A hemispherical retarding-field energy analyser with a microchannel plate detector and a high extraction field for voltage measurement in the scanning electron microscope" wird wiederum ein Sekundärelektronendetektor beschrieben, bei dem die von der Probe abgesaugten Sekundärelektronen in einem kugelsymmetrischen Gegenfeld abgebremst werden und zu einem planaren und konzentrisch um den Primärstrahl angeordneten Detektor gelangen.

Der Erfindung liegt die Aufgabe zugrunde, das Spektrometerobjektiv gemäß dem Oberbegriff des Anspruches 1 sowie das Verfahren zur Untersuchung von Proben gemäß dem Gattungsbegriff des Anspruches 12 dahingehend weiterzuentwickeln, daß einerseits eine gute Fokussierung der Sekundärelektronen gewährleistet ist und andererseits Schädigungen der Probe durch hohe Absaugfelder vermieden werden.

Diese Aufgabe wird erfindungsgemäß durch die kennzeichnenden Merkmale der Ansprüche 1 und 12 gelöst.

Weitere Ausgestaltungen der Erfindung sind Gegenstand der Unteransprüche.

Die Erfindung wird nachfolgend anhand der Zeichnungen erläutert.

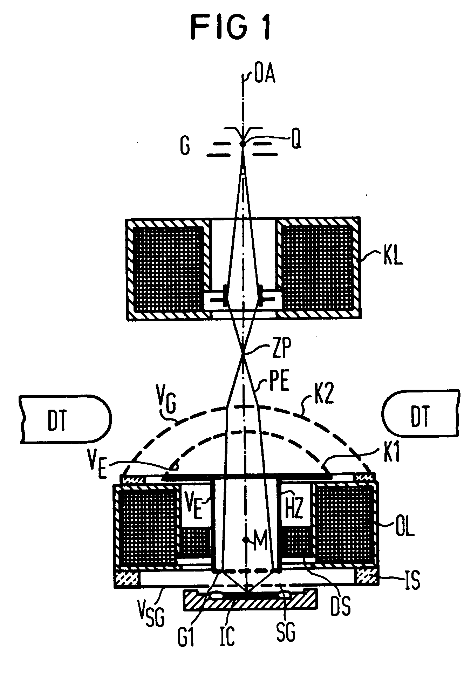

Dabei zeigen die Fig. 1 bis 3 erfindungsgemäße Spektrometerobjektive.

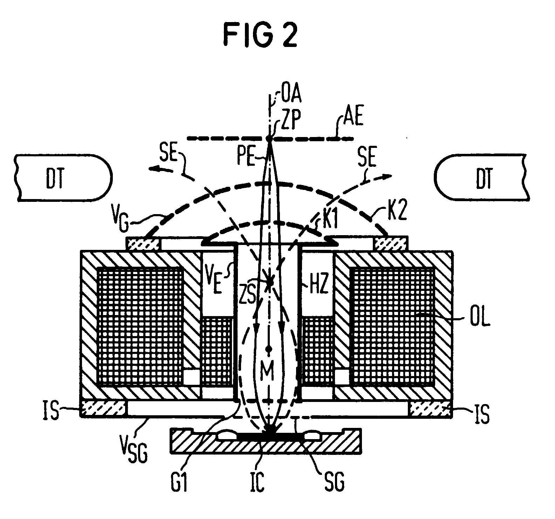

Das in den Fig. 1 und 2 schematisch dargestellte Spektrometerobjektiv besteht im wesentlichen aus einer kurzbrennweitigen, weitgehend asymmetrischen Objektivlinse OL, einem innerhalb der Magnetlinse OL symmetrisch zur optischen Achse OA angeordneten einstufigen Ablenksystem DS und einem elektrostatischen Gegenfeldspektrometer, das eine Elektrodenanordnung SG, Gl zur Beschleunigung der auf einer Probe IC, vorzugsweise in der integrierten Schaltung, ausgelösten Sekundärelektronen SE und ein ein kugelsymmetrisches Gegenfeld erzeugendes Elektrodenpaar K1/K2 aufweist. Das aus Objektivlinse OL, Ablenkeinheit OS und Spektrometer bestehende System bildet die Komponente der elektronenoptischen Säule des in Fig. 1 schematisch dargestellten Elektronenstrahlmeßgerätes, mit der die von einem Strahlerzeuger G emittierten Primärelektronen PE fokussiert und abgelenkt und die auf der Probe IC ausgelösten Sekundärelektronen SE in einen auf der optischen Achse OA liegenden Punkt ZS abgebildet werden. Zur Erzeugung einer feinen Elektronensonde mit einem Strahlquerschnitt im Submikrometerbereich (d_{PE}≈ 0,1 µm) bildet man die Elektronenquelle Q oder deren durch Kondensorlinsen KL erzeugtes Zwischenbild ZP mit Hilfe des Spektrometerobjektivs verkleinert auf die in unmittelbarer Nähe der hinteren Brennebene der Magnetlinse OL angeordnete Probe IC ab. Die Positionierung des Primärelektronenstrahles PE auf einem nicht näher bezeichneten Punkt der Probe IC, bzw. dessen zeilenförmige Ablenkung erfolgt mit Hilfe der Ablenkeinheit DS.

Zum Nachweis der am Auftreffpunkt der Primärelektronen PE ausgelösten und in einem großen Raumwinkelbereich emittierten niederenergetischen Sekundärelektronen (E_{SE}<50 eV) werden diese von der Probe IC abgesaugt und in einen homogenen elektrischen Feld in Richtung der Objektivlinse OL auf kinetische Energien zwischen etwa 1 und 5 keV beschleunigt. Erfindungsgemäß besteht die Elektrodenanordnung zum Absaugen und Beschleunigen der Sekundärelektronen SE aus einer im Strahlengang unmittelbar oberhalb der Probe IC angeordneten ebenen Elektrode SG und einer im Bereich des unteren Polschuhes der Objektivlinse OL angeordneten Gitterelektrode G1, die vorzugsweise auf hohem positiven Potential V_{E} von etwa 1 bis 5 kV liegt. Wird die isoliert am unteren Polschuh oder innerhalb des Polschuhspaltes gehalterte Elektrode SG mit einem zwischen dem Probenpotential (normalerweise Erdpotential) und dem Potential V_{E} der Elektrode G1 liegenden Potential V_{SG}, insbesondere mit einem Potential zwischen 0 und 100 Volt beaufschlagt, kann man erreichen, daß die Feldstärke im Bereich der Probe IC unterhalb eines kritischen Wertes bleibt. Außerdem ist sichergestellt, das Unebenheiten der Probenoberfläche keinen Einfluß auf die Homogenität des zwischen den Elektroden SG und G1 aufgebauten elektrischen Feldes haben. Die untere Elektrode SG ist hierbei vorzugsweise als Gitter ausgebildet und weist einen durch Isolatoren IS vom unteren Polschuh der Objektivlinse OL getrennten ringförmigen Halterungsteil auf, der mit einer variablen Spannungsquelle leitend verbunden ist. Anstelle der Gitterelektrode G1 kann selbstverständlich auch eine Lochblende verwendet werden. Die beschleunigten Sekundärelektronen SE durchlaufen die Gitterelektrode G1 und gelangen in das Magnetfeld der Objektivlinse OL zwischen den Polschuhen, in dem sie in einen auf der optischen Achse OA liegenden Punkt ZS fokussiert werden. Die Lage dieses Fokussierungspunktes ZS, der als reelles Zwischenbild der unterhalb der Probe IC liegenden virtuellen Quelle (kleinster Kaustikquerschnitt aller virtuellen Sekundärelektronenbahnen unterhalb der Probe IC) der Sekundärelektronen SE zu interpretieren ist, wird hierbei von der Höhe des an der Gitterelektrode G1 anliegenden Potentials V_{E} und der von der Primärelektronenenergie abhängigen Magnetfeldstärke im Polschuhspalt bestimmt. Eine gute Fokussierung der Sekundärelektronen SE im Feld der Objektivlinse OL ist erst durch deren Beschleunigung auf hohe kinetische Energien (E_{SE} = 1 bis 5 KeV) gewährleistet, da nur dann die Bildweiten der am Meßpunkt mit unterschiedlichen Energien (0 < E₀ < 50 eV) emittierten Sekundärelektronen SE nahezu gleich sind. Da die Primärelektronen PE die Objektivlinse OL bei hohen Beschleunigungspotentialen V_{E} ebenfalls mit hoher Energie durchlaufen, wird auch der nachteilige Einfluß des Boersch-Effektes (Coulomb-Wechselwirkung der Elektronen im Primärstrahl) auf den Sondendurchmesser in diesem Teil des elektronenoptischen Strahlengangs reduziert.

Die Abbremsung und die Energieanalyse der Sekundärelektronen SE erfolgt innerhalb, oder wie in Fig. 1 und 2 dargestellt, oberhalb der Objektivlinse OL in einem kugelsymmetrischen elektrischen Gegenfeld, daß man im Raumbereich zwischen zwei nahezu halbkugelförmigen, auf unterschiedlichem Potential V_{E} bzw. V_{G} liegenden Gitterelektroden K1 und K2 aufbaut. Während die untere Gitterelektrode K1 auf dem Potential V_{E} der Elektrode G1 liegt, wird die obere Gitterelektrode K2 üblicherweise mit Potentialen zwischen etwa -15 Volt und +15 Volt beaufschlagt. Oberhalb der das Gegenfeld aufbauenden Elektrodenanordnung K1, K2 kann noch eine in den Fig. 1 und 2 nicht dargestellte Abschirmelektrode vorgesehen sein, deren Potential vorzugsweise gleich dem Potential V_{G} der Elektrode K2 gewählt wird.

Um Lamordrehungen der Sekundärelektronen SE innerhalb der Objektivlinse OL zu vermeiden, sollte der Sekundärelektronenfokus ZS genügend weit oberhalb der Polschuhe und der Ablenkeinheit DS liegen. Die Fokussierung der Sekundärelektronen in einen oberhalb der Ablenkeinheit DS liegenden Punkt ZS der optischen Achse OA ist hierbei um so besser möglich, je kleiner die Energie der Primärelektronen PE und je höher das die Sekundärelektronen SE beschleunigende Potential V_{E} der Elektrode G1 gewählt wird. Um Störungen der Bahnbewegung der Sekundärelektronen SE durch elektrische Felder innerhalb der Objektivlinse OL zu vermeiden, ist die Gitterelektrode K1 über einen konzentrisch zur optischen Achse OA angeordneten Hohlzylinder HZ leitend mit der Elektrode G1 verbunden.

Ein vom Emissionswinkel unabhängiger Nachweis der Sekundärelektronen SE ist nur dann gewährleistet, wenn deren Bahnen parallel zu den Feldlinien des elektrischen Gegenfeldes und damit senkrecht zur Oberfläche der Elektroden K1 und K2 verlaufen. Diese Bedingung ist für den Zentralstahl der Sekundärelektronenkeule immer dann erfüllt, wenn der gemeinsame Mittelpunkt der Gitterelektroden. K1 und K2 auf der optischen Achse OA in der Mitte M des Ablenksystems DS liegt. Da die Sekundärelektronenkeule beim Rastern des Primärstrahls um diesen Punkt gekippt wird, ist ein orts- und winkelunabhängiger Nachweis der in Richtung der Symmetrieachse der Keule emittierten Sekundärelektronen SE in einem oder mehreren symmetrisch zur optischen Achse OA angeordneten Detektoren DT gewährleistet. Bei Verwendung einer symmetrischen Detektoranordnung kann oberhalb der Gitterelektroden K1 und K2 noch ein auf negativem Potential liegende Elektrode AE zum Ablenken der in Richtung der optischen Achse OA emittierten Sekundärelektronen SE vorgesehen sein.

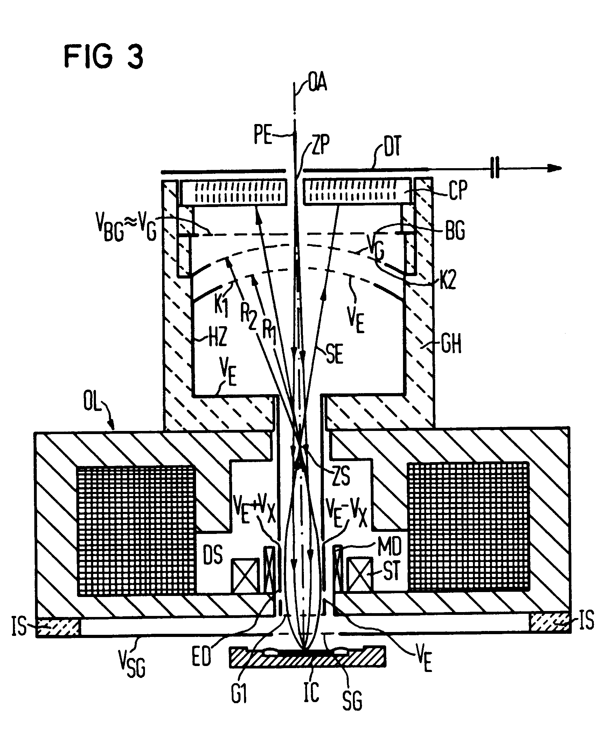

Das in Fig. 3 dargestellte Spektrometerobjektiv besteht im wesentlichen aus einer kurzbrennweitigen Objektivlinse OL, einer innerhalb der Objektivlinse OL symmetrisch zur optischen Achse OA angeordneten Ablenkeinheit DS und einem elektrostatischen Gegenfeldspektrometer, das die aus Fig. 1 und 2 bekannte Elektrodenanordnung SG/G1 zum Absaugen und Beschleunigen der Sekundärelektronen SE und eine ein kugelsymmtrisches Gegenfeld erzeugende Elektrodenanordnung K1/K2 aufweist. Das aus Objektivlinse OL, Ablenkeinheit DS und Gegenfeldspektrometer bestehende System bildet die Komponente der elektronenoptischen Säule eines Elektronenstrahlmeßgerätes, mit der die von einer Hochstromelektronenquelle emittierten Primärelektronen PE fokussiert und abgelenkt und die auf der Probe IC ausgelösten Sekundärelektronen SE vorzugsweise in das auf der optischen Achse OA liegende Zentrum ZS des kugelsymmetrischen Gegenfeldes fokussiert werden. Dieses Gegenfeld wird mit Hilfe der in einem Gehäuse GH oberhalb der Objektivlinse OL angeordneten Gitterelektroden K1 und K2 erzeugt, die jeweils Teile der Oberfläche konzentrischer Kugeln mit unterschiedlichen Radien R₁ bzw. R₂ (R₁ ≈ 30 mm, R₂ ≈ 34 mm) bilden. Da der das Zentrum des Gegenfeldes definierende Mittelpunkt ZS der den Gitterelektroden K1 und K2 zugeordneten Kugeln sehr weit oberhalb der vorzugsweise aus magnetischen und elektrischen Ablenkelementen MD bzw. ED bestehenden Ablenkeinheit DS und des Polschuhspaltes liegt, werden Lamordrehungen der Sekundärelektronen SE nach dem Durchlaufen des Zwischenbildes ZS vermieden. Zur Erzeugung eines von elektrischen Feldern freien Raumes im Bereich der Sekundärelektronenfokus ZS ist innerhalb des von einem ringförmigen Sekundärelektronendetektor DT abgeschlossenen Gehäuses GH, in dem sich außer den Elektroden K1 und K2 noch ein Abschirmgitter BG und eine Channelplate CP oder ein Halbleiterdetektor zum Nachweis der Sekundärelektronen SE befinden, ein aus drei Teilen bestehender, symmetrisch zur optischen Achse OA angeordneter Hohlzylinder HZ vorgesehen. Während der obere Teil dieses sich im Bereich der Objektivlinse OL verjüngenden Hohlzylinders HZ leitend mit dem auf einem Potential V_{E} liegenden Elektrode K1 verbunden ist, wird dessen unterer Teil probenseitig von der ebenfalls auf dem Potential V_{E} zwischen etwa 0,5 und 5 kV, insbesondere 2 kV liegenden Elektrode G1 abgeschlossen. Der von dem magnetischen Ablenkelement MD umgebene mittlere Zylinderteil ist hierbei wie in dem bekannten Spektrometerobjektiv nach E. Plies als elektrostatischer Achtpolablenker ED ausgebildet, dessen Einzelelektroden zum Ablenken des Primärstrahles mit einem weiteren Potential V_{X} beaufschlagt werden. Auf den Stigmator ST zur Kompensation des axialen Astigmatismus kann verzichtet werden, wenn man die Elektroden des Achtpolablenkers ED mit geeigneten Zusatzspannungen belegt.

Um Ablenkungen der Sekundärelektronen SE zu vermeiden, sind die mit Hilfe der Ablenkeinheit DS erzeugten homogenen elektrischen und magnetischen Feldern nach Art eines Wien'schen Filters räumlich so zueinander orientiert, daß deren Feldvektoren senkrecht aufeinander und jeweils senkrecht auf dem Geschwindigkeitsvektor der Sekundärelektronen SE stehen. Die Feldstärken E bzw. B sind hierbei so aufeinander abgestimmt, das die auf die Sekundärelektronen SE wirkende Lorenzkraft verschwindet (d. h. es muß gelten E/B = v_{SE}, wobei v_{SE} die mittlere Geschwindigkeit der Sekundärelektronen SE im Bereich der Ablenkeinheit DS bezeichnet).

Spektrometerobjektive besitzen aufgrund des dem fokussierenden Magnetfeld der Objektivlinse überlagerten elektrischen Verzögerungsfeldes deutlich kleinere Farb- und Öffnungsfehlerkonstanten als magnetische Einzellinsen. Da die Abbildungseigenschaften solcher Systeme im wesentlichen von der Homogenität und der Stärke des Verzögerungsfeldes bestimmt wird, konnte die theoretisch mögliche Auflösungsgrenze (Strahldurchmesser auf der Probe) infolge der an der Probenoberfläche vorhandenen Feldverzerrung in konventionellen Spektrometerobjektiven nicht erreicht werden. Erst mit der erfindungsgemäßen Entkopplung des Verzögerungsfeldes von der jeweiligen Probe kommen die verbesserten Abbildungseigenschaften dieser elektrostatisch-magnetischen Linsen uneingeschränkt zur Geltung.

Die Erfindung ist selbstverständlich nicht auf die in den Fig. 1 bis 3 dargestellten Ausführungsbeispiele beschränkt. So ist es beispielsweise möglich, die das kugelsymmetrische Gegenfeld erzeugende Elektrodenanordnung K1, K2 und ggf. auch das Detektorsystem vollständig innerhalb der Objektivlinse OL anzuordnen.

Die Fig. 2 und 3 betreffen Spektrometerobjektive mit integriertem Ablenksystem DS. Dieses Ablenksystem DS kann selbstverständlich auch in konventioneller Weise im Korpuskularstrahlengang oberhalb der Objektivlinse OL angeordnet werden. Hierbei muß man allerdings in Kauf nehmen, daß sich mit der Verlängerung des Strahlenganges auch der nachteilige Einfluß des Boersch-Effektes auf den Sondendurchmesser vergrößert.

Anstelle der kugelsymmetrischen Elektroden K1, K2 kann auch ein ebenes Elektrodenpaar zur Erzeugung des Gegen feldes verwendet werden. Eine vom Emissionswinkel unabhängiger Nachweis der Sekundärelektronen SE ist mit einer solchen Anordnung allerdings nicht mehr möglich.

## Patentansprüche

1. Spektrometerobjektiv für Korpuskularstrahlmeßgeräte mit einer Objekivlinse (OL) und einem Gegenfeldspektrometer, die eine korpuskularoptische Einheit zur Fokussierung eines primären Korpuskularstrahles (PE) bilden, wobei das Gegenfeldspektrometer eine erste Elektrodenanordnung (G1) zur Beschleunigung der auf einer Probe (IC) ausgelösten Sekundärkorpuskeln (SE) in Richtung der Objektivlinse (OL) und eine zweite Elektrodenanordnung (K1, K2) zum Aufbau einer die Sekundärkorpuskeln (SE) abbremsenden Potentialbarriere (V_{G}) aufweist und der ersten Elektrodenanordnung (G1) eine im Korpuskularstrahlengang unmittelbar oberhalb der Probe (IC) angeordnete Elektrode (SG) vorgelagert ist, deren Potential zwischen dem Probenpotential und dem Potential (V_{E}) der ersten Elektrodenanordnung (G1) liegt, dadurch gekennzeichnet, daß die Elektrode (SG) zur Einstellung der Feldstärke im Bereich der Probe mit einer variablen Spannungsquelle leitend verbunden ist.

2. Spektrometerobjektiv nach Anspruch 1, dadurch gekennzeichnet, daß die Elektrode (SG) an einem unteren Polschuh der Objektivlinse (OL) gehaltert ist.

3. Spektrometerobjektiv nach einem der Ansprüche 1 bis 2, dadurch gekennzeichnet, daß die Elektrode (SG) in einem Polschuhspalt der Objektivlinse (OL) gehaltert ist.

4. Spektrometerobjektiv nach einem Ansprüche 1 bis 3, dadurch gekennzeichnet, daß die Elektrode (SG) einen ringförmigen Halterungsteil aufweist.

5. Spektrometerobjektiv nach einem der Ansprüche 1 bis 4, dadurch gekennzeichnet, daß die Elektrode (SG) durch ein Gitter gebildet wird.

6. Spektrometerobjektiv nach einem der Ansprüche 1 bis 4, dadurch gekennzeichnet, daß die Elektrode (SG) durch eine Blende gebildet wird.

7. Spektrometerobjektiv nach einem der Ansprüche 1 bis 6, dadurch gekennzeichnet, daß die zweite Elektrodenanordnung (K1, K2) oberhalb der Objektivlinse (OL) angeordnet ist.

8. Spektrometerobjektiv nach einem der Ansprüche 1 bis 6, dadurch gekennzeichnet, daß die zweite Elektrodenanordnung (K1, K2) innerhalb der Objektivlinse (OL) angeordnet ist.

9. Spektrometerobjektiv nach einem der Ansprüche 1 bis 8, dadurch gekennzeichnet, daß die zweite Elektrodenanordnung (K1, K2) eine erste (K1) und eine zweite Elektrode (K2) aufweist, daß die erste Elektrode (K1) Teil der Oberfläche einer ersten Kugel mit einem ersten Radius (R₁) ist, daß die zweite Elektrode (K2) Teil der Oberfläche einer zweiten Kugel mit einem zweiten Radius (R₂) ist, wobei die Mittelpunkte der ersten und der zweiten Kugel in einem auf der optischen Achse (OA) der Objektivlinse (OL) liegenden Punkt (ZS) zusammenfallen.

10. Spektrometerobjektiv nach einem der Ansprüche 1 bis 9, gekennzeichnet durch ein in die Objektivlinse (OL) integriertes und oberhalb der ersten Elektrodenanordnung (G1) angeordnetes Ablenksystem (DS).

11. Spektrometerobjektiv nach einem der Ansprüche 1 bis 10, dadurch gekennzeichnet, daß das Ablenksystem (DS, MD, ED) nach Art eines Wien'schen Filters ausgebildet ist.

12. Verfahren zur Untersuchung von Proben, insbesondere integrierten Schaltungen, das ein Spektrometerobjektiv verwendet, wobei
- ein primärer Korpuskularstrahl (PE) durch eine Objektivlinse (OL) auf die zu untersuchende Probe fokussiert wird,
- die auf der Probe ausgelösten Sekundärkorpuskeln durch ein erstes Potential (V_{E}) durch eine erste Elektrodenanordnung (G1) in Richtung der Objektivlinse (OL) beschleunigt werden,
- wobei die ausgelösten Sekundärkorpuskeln durch ein Potential (V_{SG}) einer der ersten Elektrodenanordnung (G1) vorgelagerten Elektrode (SG) von der Probe abgesaugt werden, wobei dieses Potential zwischen dem Probenpotential und dem ersten Potential (V_{E}) liegt, und
- die Sekundärkorpuskeln anschließend durch eine von einer zweiten Elektrodenanordnung (K1, K2) aufgebauten Potentialbarriere (V_{G}) abgebremst werden,
dadurch gekennzeichnet,
daß das Potential (V_{SG}) der vorgelagerten Elektrode (SG) zur Einstellung der Feldstärke im Bereich der Probe variabel einstellbar ist.

13. Verfahren nach Anspruch 12, dadurch gekennzeichnet, daß das zweite Potential (V_{SG}) zwischen 0 und 100 V einstellbar ist.

14. Verfahren nach den Ansprüchen 12 oder 13, dadurch gekennzeichnet, daß die Potentialbarriere durch ein kugelsymmetrisches Gegenfeld gebildet wird.

15. Verfahren nach einem der Ansprüche 12 bis 14, dadurch gekennzeichnet, daß der primäre Korpuskularstrahl ablenkbar ist.

## Claims

1. Spectrometer objective for corpuscular beam measuring instruments with an objective lens (OL) and a retarding field spectrometer which form a corpuscular-optical unit for focusing of a primary corpuscular beam (PE), wherein the retarding field spectrometer has a first electrode arrangement (G1) for accelerating the secondary corpuscles (SE) triggered on a specimen (IC) in the direction of the objective lens (OL) and a second electrode arrangement (K1, K2) for establishing a potential barrier (V_{G}) which retards the secondary corpuscles (SE) and an electrode (SG) disposed in the beam path immediately above the specimen (IC) is mounted before the first electrode arrangement (G1) and has a potential between the potential of the specimen and the potential (V_{E}) of the first electrode arrangement (G1), characterised in that the electrode (SG) is conductively connected to a variable voltage source for adjustment of the field strength in the region of the specimen.

2. Spectrometer objective as claimed in Claim 1, characterised in that the first electrode is held on a lower pole piece of the objective lens (OL).

3. Spectrometer objective as claimed in one of Claims 1 to 2, characterised in that the electrode (SG) is held in a pole piece gap of the objective lens (OL).

4. Spectrometer objective as claimed in one of Claims 1 to 3, characterised in that the electrode (SG) has an annular mounting part.

5. Spectrometer objective as claimed in one of Claims 1 to 4, characterised in that the electrode (SG) is formed by a grid.

6. Spectrometer objective as claimed in one of Claims 1 to 4, characterised in that the electrode (SG) is formed by a diaphragm.

7. Spectrometer objective as claimed in one of Claims 1 to 6, characterised in that the second electrode arrangement (K1, K2) is disposed above the objective lens (OL).

8. Spectrometer objective as claimed in one of Claims 1 to 6, characterised in that the second electrode arrangement is disposed within the objective lens (OL).

9. Spectrometer objective as claimed in one of Claims 1 to 8, characterised in that the second electrode arrangement (K1, K2) has a first (K1) and a second electrode (K2), that the first electrode (K1) is part of the surface of a first sphere with a first radius (R₁), and that the second electrode (K2) is part of the surface of a second sphere with a second radius (R₂), the centre points of the first and second spheres coinciding in a point (ZS) lying on the optical axis (OA) of the objective lens (OL).

10. Spectrometer objective as claimed in one of Claims 1 to 9, characterised by a deflection system (DS) which is integrated into the objective lens (OL) and disposed above the first electrode arrangement (G1).

11. Spectrometer objective as claimed in one of Claims 1 to 10, characterised in that the deflection system (DS, MD, ED) is constructed in the manner of a Wien filter.

12. Method of examining specimens, particularly integrated circuits, using a spectrometer objective, wherein
- a primary corpuscular beam (PE) is focused by an objective lens (OL) onto the specimen to be examined,
- the secondary corpuscles triggered on the specimen are accelerated by a first potential (V_{E}) by a first electrode arrangement (G1) in the direction of the objective lens (OL),
- the triggered secondary corpuscles are extracted from the specimen by a potential (V_{SG}) of an electrode (SG) mounted before the first electrode arrangement (G1), this potential lying between the potential of the specimen and the first potential (V_{E}), and
- the secondary corpuscles are then decelerated by a potential barrier (V_{G}) established by a second electrode arrangement (K1, K2), characterised in that the potential (V_{SG}) of the preceding electrode (SG) is variably adjustable for adjustment of the field strength in the region of the specimen.

13. Method as claimed in Claim 12, characterised in that the second potential (V_{SG}) is adjustable between 0 and 100 V.

14. Method as claimed in Claims 12 or 13, characterised in that the potential barrier is formed by a spherically symmetrical retarding field.

15. Method as claimed in one of Claims 12 to 14, characterised in that the primary corpuscular beam is deflectable.

## Revendications

1. Objectif de spectromètre pour appareil de mesure à faisceau de corpuscules, comprenant une lentille d'objectif (OL) et un spectromètre à champ antagoniste qui forment un module opto-corpusculaire de focalisation d'un faisceau corpusculaire primaire (PE), le spectromètre à champ antagoniste comprenant une première disposition d'électrode (G1) pour l'accélération des corpuscules secondaires (SE) détachés d'un échantillon (IC) vers la lentille d'objectif (OL), ainsi qu'une seconde disposition d'électrodes (K1, K2) pour la création d'une barrière de potentiel (V_{G}) freinant les corpuscules secondaires (SE) et une électrode (SG) disposée immédiatement au-dessus de l'échantillon (IC) et dont le potentiel est compris entre le potentiel de l'échantillon et le potentiel (V_{E}) de la première disposition d'électrode (G1) est montée dans la marche du faisceau de corpuscules en amont de la première disposition d'électrode (G1), caractérisé en ce que l'électrode (SG) de réglage de l'intensité du champ au voisinage de l'échantillon est connectée à une source variable de tension.

2. Objectif de spectromètre selon la revendication 1, caractérisé en ce que l'électrode (SG) est fixée à une pièce polaire inférieure de la lentille d'objectif (OL).

3. Objectif de spectromètre selon l'une des revendications 1 et 2, caractérisé en ce que l'électrode (SG) est fixée dans un intervalle compris entre pièces polaires de la lentille de l'objectif (OL).

4. Objectif de spectromètre selon l'une des revendications 1 à 3, caractérisé en ce que l'électrode (SG) comporte une pièce annulaire de fixation.

5. Objectif de spectromètre selon l'une des revendications 1 à 4, caractérisé en ce que l'électrode (SG) est formée d'une grille.

6. Objectif de spectromètre selon l'une des revendications 1 à 5, caractérisé en ce que l'électrode (SG) est formée d'un diaphragme.

7. Objectif de spectromètre selon l'une des revendications 1 à 6, caractérisé en ce que la seconde disposition d'électrodes (K1, K2) est disposée au-dessus de la lentille d'objectif (OL).

8. Objectif de spectromètre selon l'une des revendications 1 à 6 caractérisé en ce que la seconde disposition d'électrodes (K1, K2) est disposée à l'intérieur de la lentille d'objectif (OL).

9. Objectif de spectromètre selon l'une des revendications 1 à 8, caractérisé en ce que la seconde disposition d'électrodes (K1, K2) comprend une première (K1) et une seconde (K2) électrode, en ce que la première électrode (K1) fait partie de la surface d'une première sphère ayant un premier rayon (R₁), en ce que la seconde électrode (K2) fait partie de la surface d'une seconde sphère ayant un second rayon (R₂), le centre des première et seconde sphères coïncidant en un point (ZS) situé sur l'axe optique (OA) de la lentille d'objectif (OL).

10. Objectif de spectromètre selon l'une des revendications 1 à 9, caractérisé par un système de déviation (DS) intégré dans la lentille d'objectif (OL) et disposé au-dessus de la première disposition d'électrode (G1).

11. Objectif de spectromètre selon l'une des revendications 1 à 10, caractérisé en ce que le système de déviation (DS, MD, ED) est conformé à la manière d'un filtre de Wien.

12. Procédé d'examen d'échantillons, en particulier de circuits intégrés, qui utilise un objectif de spectromètre, suivant lequel
- un faisceau corpusculaire primaire (PE) est focalisé par une lentille d'objectif (OL) sur un échantillon à examiner,
- les corpuscules secondaires détachés de l'échantillon par un premier potentiel (V_{E}) au moyen d'une première disposition d'électrode (G1) sont accélérés vers la lentille de l'objectif (OL),
- les corpuscules secondaires détachés sont pompés sur l'échantillon par un potentiel (V_{SG}) d'une électrode (SG) montée en amont de la première disposition d'électrode (G1), ce potentiel étant compris en un potentiel de l'échantillon et le premier potentiel (V_{E}) et
- les corpuscules secondaires sont ensuite freinés par une barrière de potentiel (V_{G}) créée par une seconde disposition d'électrodes (K1, K2)
caractérisé
en ce que le potentiel (V_{SG}) de l'électrode montée en amont (SG) est réglable de manière variable pour le réglage de l'intensité du champ au voisinage de l'échantillon.

13. Procédé selon la revendication 12, caractérisé en ce que le second potentiel (V_{SG}) est réglable entre 0 et 100 V.

14. Procédé selon les revendications 12 ou 13, caractérisé en ce que la barrière de potentiel est formée par un champ antagoniste sphérique symétrique.

15. Procédé selon l'une des revendications 12 à 14, caractérisé en ce que le faisceau de corpuscules primaires peut être dévié.
